Europäisches Patentamt

European Patent Office

Office européen des brevets

(19)

(11) Veröffentlichungsnummer: **0 226 913**
**A2**

(12) **EUROPÄISCHE PATENTANMELDUNG**

(21) Anmeldenummer: 86116960.5

(51) Int. Cl.⁴: **G01R 31/28**

(22) Anmeldetag: 05.12.86

(30) Priorität: 17.12.85 DE 3544600

(43) Veröffentlichungstag der Anmeldung:
01.07.87 Patentblatt 87/27

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Brust, Hans-Detlef**
**Martin-Luther-Strasse 2**
**D-6602 Dudweiler(DE)**

(54) **Verfahren und Anordnung zur Lokalisierung und/oder Abbildung der ein bestimmtes zeitabhängiges Signal führenden Punkte einer Probe.**

(57) Zur Überprüfung der Funktionsweise mikroelektronischer Bauelemente müssen insbesondere während der Entwicklungsphase Messungen im Innern hochintegrierter Schaltungen durchgeführt werden. Von besonderem Interesse für den Entwickler solcher Bauelemente ist hierbei die Lokalisierung und Abbildung der Bereiche einer zu untersuchenden Probe (IC), die bestimmte, den Betriebszustand der Schaltung charakterisierende Signale führen. Zur Lokalisierung der bestimmte elektrische Signale führender Punkte wird vorgeschlagen, das am jeweiligen Messpunkt anliegende Signal mit einem Primärstrahl (PE) abzutasten, und ein in einer Detektoranordnung (DT) abgeleitetes sekundäres Signal durch ein Korrelationsverfahren mit dem erwarteten oder gesuchten Signal zu vergleichen. Zur Durchführung der Korrelation wird hierbei insbesondere die Intensität des Primärstrahles (PE) oder der Strom der Sekundärkorpuskel (SE) abwechselnd mit dem gesuchten oder erwarteten Signal bzw. dem hieraus jeweils durch Negation erzeugten Signal moduliert und das gemessene Sekundärkorpuskelsignal aufintegriert. Der sich mit der durch den Signalwechsel vorgegebenen Frequenz $(f_1)$ ändernde Anteil des integrierten Sekundärkorpuskelsignals wird ausgefiltert und einer Bewerteschaltung (CMP) zugeführt, deren Ausgangssignal beispielsweise die Helligkeit des Bildschirms eines Sichtgerätes (CRT) steuert.

FIG 2

## Verfahren und Anordnung zur Lokalisierung und Abbildung der ein bestimmtes zeitabhängiges Signal führenden Punkte einer Probe

Die Erfindung betrifft ein Verfahren zur Lokalisierung und Abbildung der ein bestimmtes zeitabhängiges Signal führenden Punkte einer Probe nach dem Oberbegriff des Patentanspruchs 1, und eine Anordnung zur Durchführung des Verfahrens nach dem Obergriff des Patentanspruchs 14.

Die Überprüfung der Funktionsweise hochintegrierter Schaltungen erfolgt üblicherweise in rechnergesteuerten Testsystemen, in denen vorhandene Fehler durch Analyse der an den Ausgängen der untersuchten Schaltung in Abhängigkeit von den jeweils eingespeisten Bitmustern gemessenen Spannungspegel zwar erkannt, aber nur sehr - schwer lokalisiert werden können. Deshalb müssen insbesondere während der Entwicklungsphase zusätzliche Messungen im Innern hochintegrierter Schaltungen durchgeführt werden. Als für diese Zwecke besonders geeignet haben sich die in allen Bereichen der Entwicklung und Fertigung mikroelektronischer Bauelemente eingesetzten Elektronenstrahl-Meßverfahren herausgestellt, mit denen beispielsweise die dynamische Potentialverteilung in integrierten Schaltungen abgebildet (hier sind insbesondere die dem Fachmann unter der Bezeichnung "Voltage Coding" bzw. "Logic-State Mapping" bekannten Verfahren zu nennen) oder der zeitliche Potentialverlauf an einzelnen Knotenpunkten bestimmt werden kann ("Waveform Measurement").

Ein Verfahren zur Lokalisierung und Abbildung der Leiterbahnen einer integrierten Schaltung die ein Signal einer bestimmten Frequenz führen, ist aus der Veröffentlichung von H.-D. Brust "Frequency Tracing and Mapping: Novel Electron Beam Testing Methods" (Proceedings der Microciruit Engineering Conference, Berlin, September 1984, Seite 412 bis 425) bekannt. Mit diesem bekannten Verfahren kann allerdings nicht zwischen Signalen gleicher Frequenz aber unterschiedlichen Signalverlaufs unterschieden werden.

In der deutschen Patentanmeldung P 34 28 965.8 wurde deshalb ein Verfahren vorgeschlagen, mit dem die, ein bestimmtes elektrisches Signal führenden Leiterbahnen eines ICs lokalisiert und abgebildet werden können. Bei diesem sogenannten "Logic-State Tracing"-Verfahren (LST) werden allerdings nicht nur die das gesuchte Signal führenden Leiterbahnen hell auf einem Sichtgerät dargestellt, sondern unter Umständen auch die Bereiche der untersuchten Probe, in denen aufgrund des Material-oder Topographiekontrastes besonders hohe oder niedrige Sekundärelektronenströme auftreten.

Der vorliegenden Erfindung liegt die Aufgabe zugrunde, ein Verfahren und eine Anordnung der eingangs genannten Art anzugeben, mit deren Hilfe des möglich ist zu überprüfen, ob an einem Punkt einer zu untersuchenden Probe das erwartete, durch einen in der Probe ablaufenden periodischen Vorgang hervorgerufene Signal vorliegt, bzw. bei fehlerhaften Proben festzustellen, ob ein bestimmtes Signal überhaupt noch auftritt. Weiterhin soll sichergestellt sein, daß der störende Einfluß des Material-und Topographiekontrastes weitgehend unterdrückt wird.

Diese Aufgabe wird erfindungsgemäß durch ein Verfahren nach Anspruch 1 und durch eine Anordnung nach Anspruch 14 gelöst. Ausgestaltungen und Vorteile der Erfindung sind in den Unteransprüchen, der Beschreibung und der Zeichnung dargestellt.

Der mit der Erfindung erzielbare Vorteil liegt insbesondere darin, daß durch Unterdrückung des störenden Einflusses des Material-und Topographiekontrastes nur die, das gesuchte Signal führenden Bereiche der Probe (beispielsweise Leiterbahnen einer integrierten Schaltung) abgebildet werden.

Die Erfindung wird nachfolgend anhand der Zeichnungen näher erläutert. Dabei zeigen:

Fig. 1 eine Anordnung zur Durchführung des erfingsgemässen Verfahrens

Fig. 2 eine Weiterbildung der Anordnung nach Fig. 1

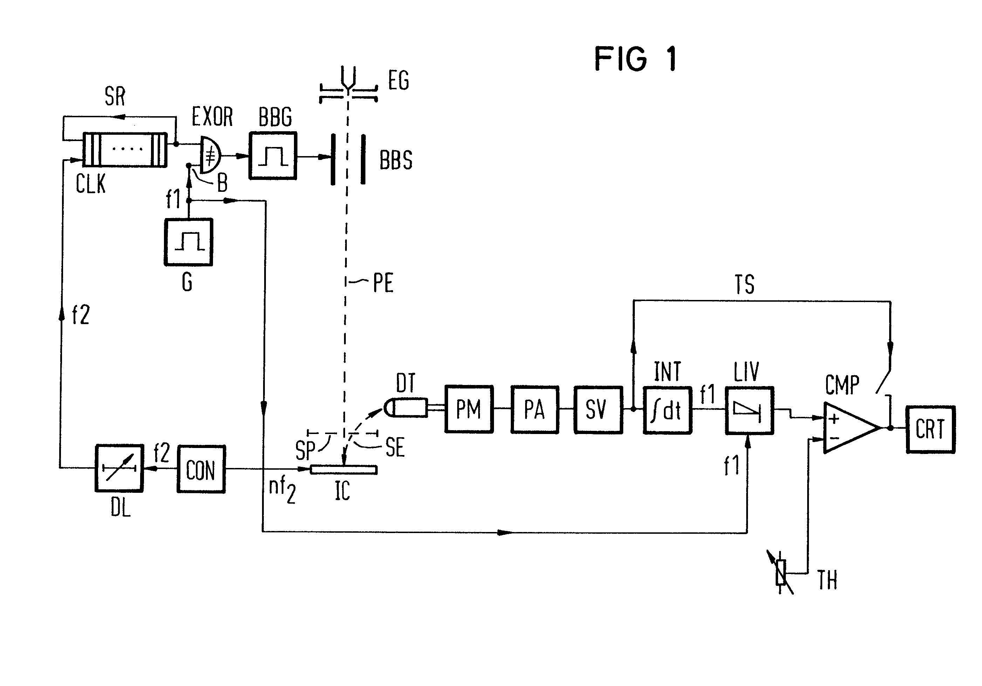

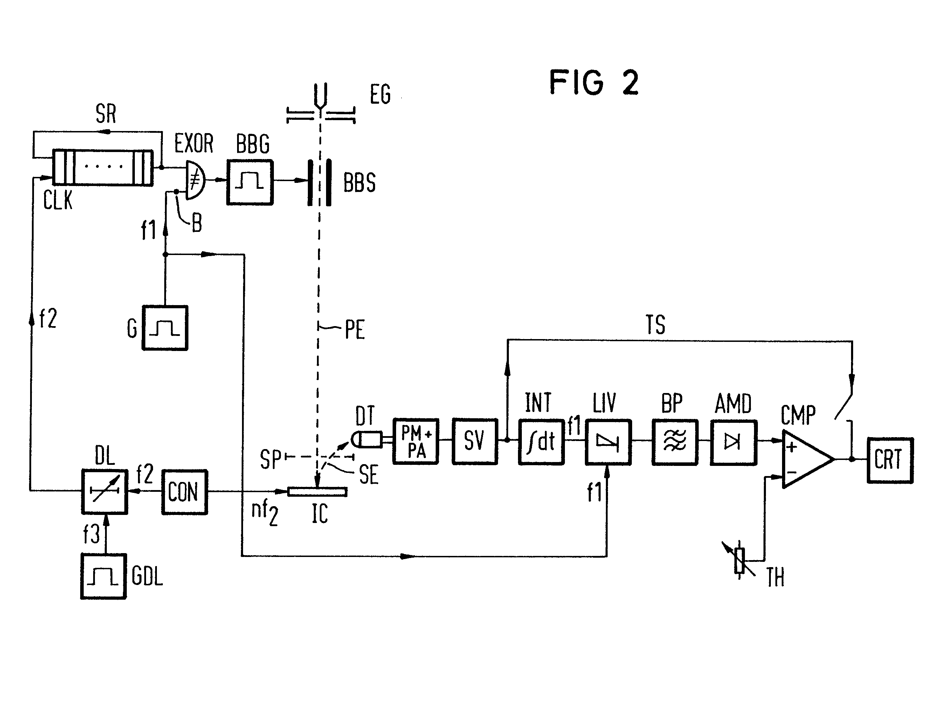

Bei der in Fig. 1 dargestellten Anordnung zur Durchführung des erfindungsgemäßen Verfahrens wird ein fein gebündelter Primärelektronenstrahl PE in der elektronenoptischen Säule eines beipielsweise aus den US Patentschriften 4 220 853 oder 4 223 220 bekannten Elektronenstrahl-Meßgerätes erzeugt. Diese elektronenoptische Säule weist neben einer Vielzahl, in den Fig. 1 und 2 aus Gründen der Übersichtlichkeit nicht dargestellten Blenden und magnetischen Linsensystemen zur Strahlformung, Strahlablenkung und zur Strahlfokussierung, eine im wesentlichen aus Kathode, Anode und Wehnelt-Elektrode bestehende Elektronenkanone EG und ein über den Strahlaustastgenerator BBG angesteuertes Strahlaustastsystem BBS auf. Zum Nachweis der am jeweils gewählten Auftreffpunkt des Primärelektronenstrahls PE auf der Probe IC ausgelösten Sekundärelektronen SE ist beispielsweise ein aus Absaugnetz und Szintillator aufgebauter Detektor DT vorgesehen. Der im Detektor DT nachweisbare, in seiner Intensität an den einzelnen Meßpunkten infolge des unterschiedlichen Potential-, Material-und Tophographiekontrastes schwankende Sekundärelektronenstrom erzeugt im Szintillator Lichtimpulse, die über einen Lichtleiter dem Photomultiplier PM zugeführt, und hier in ein sekundäres elektrisches Signal umgewandelt werden. Anschliessend wird das so erzeugte Sekundärelektronensignal in einem Vorverstärker PA weiter verstärkt, einer Schaltung SV zur Verbesserung des Signal-Rausch Verhältnisses zugeführt (beispielsweise Glättung des Signals durch Tiefpassfilterung), und in einem nachgeschalteten Integrator INT über ein bestimmtes Zeitintervall aufintegriert. Dem Detektor DT kann noch ein Spektrometer SP, vorzugsweise ein Gegenfeldspektrometer wie es beispielsweise aus der US Patentschrift 4 292 519 bekannt ist, zur Messung der vom Probenpotential abhängigen Verschiebung der Energieverteilung der Sekundärelektronen SE vorgeschaltet sein. In Fig. 1 ist dieses Spektrometer SP schematisch durch eine ebene Gegenfeldelektrode angedeutet.

Als Probe IC ist vorzugsweise eine mit Nennfrequenz arbeitende integrierte Schaltung vorgesehen, in die man über die Ansteuerung CON der zu untersuchenden Problemstellung angepaßte Testprogramme periodisch einspeist. Entsprechend der Schaltungsstruktur der Probe IC treten dann während des Testzyklus an Knotenpunkten und Leiterbahnen charakteristische, den Betriebszustand definierende Signale auf, die zur Überprüfung der Funktionsweise mit den beispielsweise aus Simulationsrechnungen gewonnenen Signalverläufen verglichen werden können.

Die integrierte Schaltung IC kann selbstverständlich durch jede Probe ersetzt werden, die an den für einen Primärelektronenstrahl PE zugänglichen Stellen elektrische Signale führende Leiterbahnen oder Kontaktpunkte aufweist.

Das erfindungsgemäße Verfahren erlaubt die Lokalisierung und Abbildung der Leiterbahnen einer integrierten Schaltung IC, die ein bestimmtes, gesuchtes Signal führen. Da sich das im folgenden beschriebene Ausführungsbeispiel speziell auf binäre Signale bezieht ist das gesuchte Signal dann ein bestimmtes Bitmuster.

Wie schon bei dem in der deutschen Patentanmeldung P 34 28 965.8 vorgeschlagenen Verfahren wird das an dem jeweils ausgewählten Meßpunkt der Probe IC gemessene Signal mit Hilfe eines Korrelationsverfahrens mit dem gesuchten Bitmuster verglichen. Diese nachfolgend beschriebene Korrelation muß bei hochfrequenten Signalen - (Taktfrequenz > 5 MHz) wegen der geringen Bandbreite der Detektoranordnung vom Primärelektronenstrahl PE über den Mechanismus des Potentialkontrastes durchgeführt werden.

Bezeichnet f(t) das Signal an einem Punkt der Probe IC, und g(t) das gesuchte Bitmuster, so muß die in Gleichung 1) definierte Korrelation ausgeführt werden.

$$c := \int f(t) \bullet g(t) \bullet dt \quad 1)$$

Da der Sekundärelektronenstrom $i_{SE}$ proportional zum Primärelektronenstrom $i_{PE}$ ist, und zudem vom Signal f(t) am Meßpunkt abhängt gilt

$$i_{SE} = h(f(t)) \bullet i_{PE} \quad 2)$$

wobei h(f(t)) den Einfluß der Potentialkontrastkennlinie auf den Sekundärelektronenstrom $i_{SE}$ kennzeichnet.

Moduliert man nun den Primärelektronenstrom $i_{PE}$ in seiner Amplitude oder Intensität mit den gesuchten Signal, indem man beispielsweise den Primärelektronenstrahl PE entsprechend dem zeitlichen Auftreten der "HIGH-und "LOW"-Werte des gesuchten Bitmusters g(t) ein-und austastet, und integriert gleichzeitig den im Detektor DT gemessenen Sekundärelektronenstrom $i_{SE}$, so wird gerade die in Gleichung 1) definierte Korrelation ausgeführt. Die Nichtliniarität der Potentialkontrastkennlinie stört in diesem Zusammenhang nicht, da nur binäre Signale g(t) und f(t) vorliegen.

Stimmen das gesuchte Bitmuster g(t) und das Signal am Meßpunkt f(t) innerhalb des gewählten Integrationszeitraumes in der Reihenfolge ihrer "HIGH"-und "LOW"-Werte und in der Phase überein, so ist der Wert des Integrals maximal

$$c_{max} = \int f(t) \bullet g(t) \bullet dt \text{ falls } g(t) = f(t) \quad 3)$$

Ist hingegen das gesuchte Bitmuster g(t) gerade die negation des Signals f(t), so ist der Wert des Integrals minimal

$$c_{min} = \int f(t) \bullet g(t) \bullet dt \text{ falls } g(t) = Neg(f(t)) \quad 4)$$

Für alle anderen Signale f(t) bewegt sich der Wert des Integrals zwischen diesen Grenzen $c_{max}$ und $c_{min}$. Dies ist auch dann der Fall, wenn der Meßpunkt das gesuchte Bitmuster führt, dieses Bitmuster aber zeitlich verzögert, also phasenverschoben auftritt.

Zur Unterdrückung des die Messungen in unerwünschter Weise beeinflußenden Material-oder Topographiekontrastes wird der Primärelektronenstrahl PE erfindungsgemäß abwechselnd mit dem gesuchten Bitmuster g(t) und dessen Negation moduliert, d. h. in Abhängigkeit von den in der jeweiligen Bitfolge auftretenden "HIGH"-und "LOW"-Werten mit Hilfe des Strahlaustastsystems BBS ein-und ausgetastet.

Hierzu wird das gesuchte Bitmuster vor Beginn der Messung in das Schieberegister SR eingelesen, dessen Inhalt man während der Messung mit einer durch das äußere Taktsignal CLK vorgegebenen Frequenz $f_2$ zyklisch verschiebt. Das Taktsignal CLK kann beispielsweise aus der von der Ansteuerung CON erzeugte Taktfrequenz $nf_2$ durch Frequenzteilung gewonnen werden. Zur Modulation des Primärelektronenstrahls PE wird das dem gesuchten Bitmuster entsprechende Ausgangssignal des Schieberegisters SR über das EXOR-Gatter wahlweise negiert oder nichtnegiert dem das Strahlaustastsystem BBS steuernden Strahlaustastgenerator BBG zugeführt.

Die Ansteuerung des Strahlaustastsystems BBS kann hierbei auch direkt über das verstärkte Ausgangssignal des EXOR-Gatters erfolgen.

Zur Umschaltung des EXOR-Gatters von der nichtnegierenden auf die negierende Betriebsweise wird dessen Eingang B mit dem Ausgang des Signalgenerators G verbunden, wobei die durch den Signalgenerator G vorgegebene Umschaltfrequenz $f_i$ klein im Vergleich zur Wiederholfrequenz der gesuchten Bitmusterfolge am jeweiligen Meßpunkt gewählt werden muß.

Ist der Primärelektronenstrahl PE beispielsweise auf eine das gesuchte Bitmuster führenden Leiterbahn positioniert, so liefert der Integrator INT ein Ausgangssignal, dessen Amplitude mit der Umschaltfrequenz $f_i$ zwischen den durch die in Gleichung 3) und 4) definierten Extremwerte $c_{min}$ und $c_{max}$ wechselt. Die Schwankungsamplitude

$$\Delta c: = c_{max} - c_{min} \quad 5)$$

ist also immer dann maximal, wenn die betreffende Leiterbahn das gesuchte Bitmuster führt.

Liegt das gesuchte Bitmuster hingegen nicht vor, bzw. tritt es zeitlich verzögert, also phasenverschoben auf, so ist die Schwankung des vom Integrator INT erzeugten Ausgangssignals stets kleiner als die in Gleichunng 5) definierte Größe c. Dies gilt insbesondere auch für die Bereiche der Probe IC, in denen aufgrund spezieller Materialien (Oxidschichten) oder der Topographie (Kanten) besonders viele oder wenige Sekundäreelektronen SE emittiert und im Detektor DT nachgewiesen werden. Da das in diesen Bereichen im wesentlichen durch den Material-oder Topographiekontrast bestimmte und im Integrator INT aufintegrierte Sekundärelektronen-Signal weitgehend unabhängig von dem den Primärelektronenstrahl PE jeweils modulierenden negierten oder nichtnegierten Bitmuster nahezu konstant bleibt, ist die Schwankung des Integratorausgangsignals auch in diesem Falle kleiner als c. Um festzustellen, ob ein Punkt das gesuchte Signal führt, genügt es also, die Schwankung des Integratorausgangssignals beispielsweise mit einem phasenempfindlichen Detektor zu bestimmen, und diese mit einem Schwellenwert TH - ($\Delta c \geq TH$) zu vergleichen. Nach der in Fig. 1 dargestellten Anordnung ist dem Integrator INT ein Lock-in-Verstärker LIV nachgeschaltet, dessen Referenzeingang RE mit dem Ausgang des Signalgenerators G verbunden ist. Anstelle dieses phasenempfindlichen Detektors LIV kann beispielsweise ein, auf die Umschaltfrequenz $f_i$ abgestimmtes Bandpaßfilter mit nachgeschaltetem Amplitudendemodulator (hierfür kommt beispielsweise ein Spitzenwertgleichrichter in Betracht) eingesetzt werden. Der Vergleich der Schwankungsamplitude mit der variablen Ansprechschwelle TH erfolgt im Komparator CMP, dessen Plus-Eingang mit dem Ausgangssignal des Lock-in-Verstärkers LIV beschaltet ist. Der Komparator CMP erzeugt immer nur dann ein Signal, wenn die Schwankung des Integratorausgangsignals oberhalb der Ansprechschwelle TH liegt, also immer dann, wenn der jeweilige Meßpunkt das gesuchte Bitmuster phasenrichtig führt.

Unter Umständen kann auf einen Integrator als eigenständiges Bauelement ganz verzichtet werden, da für hohe Frequenzen der Detektor DT und für niedrige Frequenzen bei geeigneter Wahl der Rastergeschwindigkeit die Bildröhre CRT des Raster-Elektronenmikroskops selbst integrierend wirken.

Zur Darstellung der ein bestimmtes Bitmuster führenden Leiterbahnen der Probe IC wird deren Oberfläche zeilen-bzw. punktweise mit dem Primärelektronenstrahl PE abgetastet. Diese Abtastung muß hierbei so langsam erfolgen, daß das oben beschriebene Korrelationsverfahren an jedem Punkt der Oberfläche innerhalb des Zeitintervalles, in dem das erwartete Signal auftreten kann, auch tatsächlich durchgeführt wird. Der primäre Korpuskularstrahl muß also mindestens während der Integrationsdauer auf jedem Meßpunkt positioniert bleiben. Ist dies nicht der Fall, kann die Messung periodisch vorgenommen werden. Zur Abbildung der das gesuchte Bitmuster phasenrichtig führenden Oberflächenstrukturen der Probe IC zeichnet man das Ausgangssignal des Komparators CMP in Abhängigkeit vom jeweils mit dem Primärelektronenstrahl PE beaufschlagten Meßpunkt auf. Eine einfache Aufzeichnungsmöglichkeit besteht darin, das Ausgangssignal des Komparators CMP zur Modulation der Intensität des synchron mit dem Primärelektronenstrahl PE abgelenkten Schreibstrahls der Bildröhre CRT des Elektronenstrahl-Meßgerätes heranzuziehen, so daß alle Leiterbahnen, die das gesuchte Signal führen, hell dargestellt werden. Zur besseren Lokalisierung dieser Strukturen innerhalb der hochkomplexen Schaltungen kann es von Vorteil sein, dem Ausgangssignal des Komparators CMP ein Topographiesignal - (beispielsweise das konventionelle Sekundärelektronenbild der Probe IC) zu überlagern und dieses gleichzeitig darzustellen. In Fig. 1 ist dies schematisch durch die Signalleitung TS angedeutet.

Mit der bisher beschriebenen Anordnung kann nur überprüft werden, ob an dem untersuchten Meßpunkt ein bestimmtes Bitmuster phasenrichtig auftritt. Die Phase zu der man die Überprüfung vornimmt, kann hierbei über das Verzögerungsglied DL eingestellt werden. Da nur die Phasendifferenz von Interesse ist, kann das Verzögerungsglied DL selbstverständlich auch zwischen Ansteuerung CON und Probe IC angeordnet werden. Eine erfindungsgemäße Anordnung mit der diese Überprüfung phasenunabhängig durchführbar ist, mit der also getestet werden kann, ob das erwartete Bitmuster am Meßpunkt überhaupt vorliegt, ist in Fig. 2 dargestellt, in der gleiche Bezugszeichen die gleichen, schon in Zusammenhang mit Fig. 1 beschriebenen Anordnungselemente bezeichnen.

Das elektrisch steuerbare Verzögerungsglied DL wird hierbei von einem Generator GDL mit der Frequenz $f_3$ angesteuert, so daß sich mit der Verzögerungszeit auch die Phasenlage des mit dem gesuchten Bitmuster bzw. mit dessen Negation modulierten Primärelektronenstrahls PE relativ zu dem am Meßpunkt anliegenden Signal periodisch mit der Frequenz $f_3$ ändert. Damit weist das Ausgangssignal des Integrators INT neben der durch das Umschalten des EXOR-Gatters erzeugten Signalkomponente mit der Frequenz $f_1$ auch eine Signalkomponente mit der im allgemeinen niedrigeren Frequenz $f_3$ auf, falls der Meßpunkt das gesuchte Bitmuster führt. Die Signalkomponente mit der Frequenz $f_1$ kann man wieder mit Hilfe eines phasenempfindlichen Detektors ausfiltern, so daß am Ausgang des in Fig. 2 dargestellten Lock-in-Verstärkers LIV ein Signal der Frequenz $f_3$ abgreifbar ist, das man dem Eingang des auf diese Frequenz abgestimmten Bandpaßes BP zuführt. Die Amplitude dieses Signals der Frequenz $f_3$ wird anschließend in dem nachgeschalteten Amplitudendemodulators AMD bestimmt, und in dem Komparator CMP mit der variablen Ansprechschwelle TH verglichen, wobei das Komparatorausgangssignal in Abhängigkeit von dem Ort des Meßpunktes auf der Probe IC wieder aufgezeichnet oder zur Steuerung der Intensität des Schreibstrahls der Bildröhre CRT herangezogen werden kann.

Selbstverständlich kann man die Frequenz $f_3$ nicht nur mit einem Bandpaßfilter BP sondern auch phasenempfindlich, etwa mit Hilfe eines Lock-in-Verstärkers, ausfiltern. In diesem Fall wird natürlich auch der Amplitudendemodulator AMD überflüssig.

Außerdem ist es möglich, die Frequenz $f_1$, mit der das EXOR-Gatter umgeschaltet wird, auch kleiner als die Frequenz $f_3$, mit der das Verzögerungsglied DL angesteuert wird, zu wählen. In diesem Fall muß man allerdings zuerst die Frequenz $f_3$ und dann erst die Frequenz $f_1$ aus dem Sekundärelektronensignal ausfiltern, da nun die Frequenz $f_1$ als Modulation auf der jetzt als Trägerfrequenz wirkenden Frequenz $f_3$ erscheint. In Fig. 2 treten dann der Lock-in-Verstärker LIV und das Bandpaßfilter BP mit nachgeschaltetem Amplitudendemodulator AMD innerhalb der Signalkette in umgekehrter Reihenfolge auf.

Eine Änderung der Phasenlage des mit dem gesuchten Bitmuster bzw. dessen Negation modulierten Primärelektronenstrahles PE relativ zu dem am Meßpunkt anliegenden Signal ist auch einfach dadurch erreichbar, daß man die Frequenz $f_2$, mit dem die Bitfolge im Schieberegister SR zyklisch verschoben wird, und die von der Ansteuerung CON erzeugte Taktfrequenz leicht gegeneinander versetzt. Das dann am Ausgang des Lock-in-Verstärkers LIV abgreifbare Signal mit der vorgegebenen Differenzfrequenz kann wieder einem auf diese Frequenz abgestimmten Bandpaßfilter zugeführt werden.

Bei den in den Fig. 1 und 2 dargestellten Anordnungen wird die obere Grenzfrequenz durch das verwendete Strahlaustastsystem BBS bestimmt. Da zur Zeit bereits in GHz-Bereich arbeitende Strahlaustastsysteme BBS zur Verfügung stehen, können die erfindungsgemäßen Anordnungen zur Überprüfung integrierter Schaltungen IC unter realen Betriebsbedingungen eingesetzt werden.

Nach einer weiteren Ausgestaltung der Erfindung wird im Unterschied zu den zuvor beschriebenen Anordnungen nicht der Primärelektronenstrahl PE, sondern der Sekundärelektronenstrom $i_{SE}$ abwechselnd mit dem gesuchten Bitmuster bzw. dessen Negation moduliert. Als Modulator kann ein Sekundärelektronen-Spektrometer SP, wie es beispielsweise aus der US Patentschrift 4 292 419 bekannt ist, eingesetzt werden, bei dem das gesuchte Signal-oder Bitmuster bzw. dessen Negation die Höhe des im Spektrometer SP aufgebauten Potentialwalls und damit auch die Intensität des im Detektor DT nachweisbaren Sekundärelektronenstromes $i_{SE}$ steuert. In einer Anordnung zur Durchführung dieses Verfahrens wird das Ausgangssignal des EXOR-Gatters in Abwandlung zu den in Fig. 1 und 2 dargestellten Anordnungen einem Eingang eines Addierers zugeführt, dessen Ausgang mit der Gegenfeldelektrode des Spektrometers SP verbunden ist. Die Ansteuerung der Gegenfeldelektrode über einen Addierer bietet insbesondere den Vorteil, daß der Arbeitspunkt des Spektrometers optimal eingestellt werden kann. Ansonsten bleibt die in den Fig. 1 und 2 dargestellte Meßkette zur Signalverarbeitung unverändert.

Der Vorteil dieses Verfahrens liegt insbesondere darin, daß kein Strahlaustastsystem BBS erforderlich ist. Die mit einer solchen Anordnung erreichbare Grenzfrequenz ist allerdings wegen der relativ hohen Kapazität des Spektrometers SP geringer als die der Anordnungen nach Fig. 1 und 2. Zur Modulation des Sekundärelektronenstromes $i_{SE}$ kann auch ein Detektor DT eingesetzt werden, dessen Absaugspannung vom dem gesuchten Signal-oder Bitmuster gesteuert wird. Auch in einer Anordnung zur Durchführung dieses Verfahrens wird das Ausgangssignal des EXOR-Gatters vorteilhafterweise einem Eingang eines Addierers zugeführt, dessen Ausgang wiederum mit der Absaugelektrode des Detektors DT verbunden ist. Ansonsten bleibt auch hier die in den Fig. 1 und 2 dargestellte Meßkette zur Signalverarbeitung unverändert.

Nach einer weiteren Ausgestaltung der Erfindung wird anstelle des Primärelektronenstrahles PE das in einer Signalverarbeitung (beispielsweise einer Detektor-Photomultiplier-Verstärkeranordnung) erzeugte Sekundärelektronensignal mit dem gesuchten Signal-oder Bitmuster, beispielsweise mit Hilfe einer Gate-Schaltung, moduliert. Eine Anordnung zur Durchführung dieses Verfahrens weist mit Ausnahme des Strahlaustastsystems BBS und des zugeordneten Signalgenerators BBG alle in den Fig. 1 und 2 dargestellten Schaltungselemente und zusätzlich noch einen beispielsweise zwischen der Schaltung SV zur Verbesserung des Signal-Rausch-Verhältnisses und dem Integrator INT angeordneten Mischer auf. Ein zweiter Eingang dieses Mischers ist hierbei wiederum mit dem Ausgang des EXOR-Gatters verbunden. Als Mischer kommt für das gesuchte analoge Signal beispielsweise ein Multiplizierer, für gesuchte digitale Signale (Bitmuster) beispielsweise ein einfacher elektronischer Schalter in Betracht.

Nach einer weiteren Ausgestaltung der Erfindung ver zichtet man auf eine Modulation mit einer Frequenz f, und kennzeichnet stattdessen den Primär-bzw. Sekundärelektronenstrom bzw. das Sekundärelektronensignal auf andere Art und Weise durch eine Modulation.

Diese Kennzeichnung kann dazu benutzt werden, die zugehörige Schwankungsamplitude mit Hilfe eines geeigneten Filters bzw. Demodulators aus dem verarbeiteten Sekundärelektronensignal auszufiltern. Eine einfache Möglichkeit der Realisierung besteht beispielsweise darin, in der in Fig. 1 dargestellten Anordnung den Eingang B des EXOR-Gatters über einen Zufallsbitfolgegenerator -

(ein sog. pn oder pseudo n oise -Generator) anzusteuern und die interessierende Schwankungsamplitude mit Hilfe eines auf die Zufallsbitfolge abgestimmten Korrelators auszufiltern.

Auch bei den oben beschriebenen Verfahren und Meßanordnungen kann es von Vorteil sein, dem Ausgangssignal zur zweidimensionalen Abbildung der untersuchten Probe IC das Sekundärelektronen-Topographiesignal oder ein anderes Topographiesignal zu überlagern. Dies erleichtert die Lokalisierung der abgebildeten, das gesuchte Signal-oder Bitmuster führenden Bereiche auf der Probenoberfläche.

Selbstverständlich muß das an jedem Punkt der Probe IC gemessene Sekundärelektronen-Signal nicht ausschließlich durch Potentialkontrast entstehen. Jeder andere Kontrastmechanismus, bei dem die Sekundärelektronen SE durch ein am Meßpunkt anliegendes Signal beeinflußt werden, ist hierfür geeignet. So werden die Sekundärelektronen SE beispielsweise bei Verwendung von Magnetblasenspeichern als Probe IC durch lokale magnetische Felder abgelenkt (Magnetischer Kontrast).

Die Erfindung ist selbstverständlich nicht auf die Verwendung von Elektronen als Primär-und Sekundärkorpuskel beschränkt. So können neben Elektronen, je nach Anwendungsfall, auch Ionen oder andere Korpuskel als Primär-bzw. Sekundärkorpuskel in Betracht kommen. Zur Erzeugung eines Primärstrahls kann selbstverständlich auch Laser verwendet werden.

**Ansprüche**

1. Verfahren zur Lokalisierung und/oder Abbildung der ein bestimmtes zeitabhängiges Signal führenden Punkte einer Probe in einem Rastermikroskop, bei dem ein Primärstrahl auf mindestens einen, ein erstes zeitabhängiges Signal führenden Punkt einer Probe fokussiert wird, bei dem die an diesem Punkt ausgelösten sekundären Korpuskel in einer Detektoranordnung nachgewiesen werden, bei dem in einer nachgeschalteten Signalverarbeitung aus dem in der Detektoranordnung gemessenen Sekundärkorpuskelstrom ein sekundäres elektrisches Signal erzeugt wird, in dem ein zwischen einer Anordnung zur Erzeugung des primären Korpuskularstrahls und der Signalverarbeitung, oder ein innerhalb der Signalverarbeitung auftretendes Signal mit dem bestimmten Signal moduliert, und das sekundäre Signal integriert wird, und bei dem der Grad der Übereinstimmung des ersten und des bestimmten Signals aus dem durch Integration erzeugten Meßsignal abgeleitet wird, dadurch **gekennzeichnet,** daß zur Modulation das bestimmte Signal und das aus diesem durch Negation erzeugte Signal verwendet wird und daß diese Signale abwechselnd zur Modulation herangezogen werden.

2. Verfahren nach Anspruch 1, dadurch **gekennzeichnet**, daß der vorzunehmende Signalwechsel periodisch mit einer ersten Frequenz ($f_1$) erfolgt, und daß aus dem durch Integration erzeugten Meßsignal ein erster Signalanteil mit dieser ersten Frequenz ($f_1$) ausgefiltert wird.

3. Verfahren nach Anspruch 1 oder 2, dadurch **gekennzeichnet**, daß das negierte und das bestimmte Signal um eine feste, frei wählbare Phase gegenüber dem ersten Signal verschoben ist.

4. Verfahren nach einem der Ansprüche 1 bis 3, dadurch **gekennzeichnet**, daß die Phase mit der das bestimmte und das negierte Signal gegenüber dem ersten Signal verschoben ist, periodisch mit einer zweiten Frequenz ($f_2$) verändert wird, und daß aus dem durch Integration erzeugten Meßsignal ein erster Signalanteil mit der ersten Frequenz ($f_1$) und aus dem ersten Signalanteil ein zweiter Signalanteil mit der zweiten Frequenz ($f_2$) ausgefiltert wird.

5. Verfahren nach Anspruch 1 oder 3, dadurch **gekennzeichnet**, daß der vorzunehmende Signalwechsel durch eine Bitfolge gesteuert wird und daß ein diesem Bitmuster entsprechender Signalanteil aus dem durch Integration erzeugten Meßsignal ausgefiltert wird.

6. Verfahren nach einem der Ansprüche 1 bis 5, dadurch **gekennzeichnet**, daß die Intensität des Primärstrahles ($i_{PE}$) mit dem bestimmten Signal und dessen Negation moduliert wird.

7. Verfahren nach einem der Ansprüche 1 bis 5, dadurch **gekennzeichnet**, daß der Strom der sekundären Korpuskel ($i_{SE}$) mit dem bestimmten Signal und dessen Negation moduliert wird.

8. Verfahren nach einem der Ansprüche 1 bis 5, dadurch **gekennzeichnet**, daß ein in der Signalverarbeitung erzeugtes sekundäres Signal mit dem bestimmten Signal und dessen Negation moduliert wird.

9. Verfahren nach einem der Ansprüche 1 bis 8, dadurch **gekennzeichnet**, daß in einer Bewerteschaltung (CMP) die Amplitude des ersten oder zweiten Signalanteils mit einem einstellbaren Schwellwert (TH) verglichen wird.

10. Verfahren nach einem der Ansprüche 1 bis 9, dadurch **gekennzeichnet**, daß die Probenoberfläche oder wenigstens ein Teilbereich der Probenoberfläche mindestens einmal mit dem Primärstrahl (PE) abgetastet wird.

11. Verfahren nach einem der Ansprüche 1 bis 10, dadurch **gekennzeichnet** , daß der erste oder zweite Signalanteil und/oder das Ausgangssignal der Bewerteschaltung (CMP) aufgezeichnet wird.

12. Verfahren nach einem der Ansprüche 1 bis 11, dadurch **gekennzeichnet**, daß an jedem der mit dem Primärstrahl (PE) abgetasteten Punkte der Probe (IC) auch ein Topographiesignal aufgenommen wird.

13. Verfahren nach einem der Ansprüche 1 bis 12, dadurch **gekennzeichnet**, daß einem Ausgangssignal der Bewerteschaltung (CMP) ein Topographiesignal überlagert wird, und daß das dadurch erzeugte Signal mit Hilfe eines Aufzeichnungsmediums (CRT) aufgezeichnet wird.

14. Anordnung zur Lokalisierung und/oder Abbildung der ein bestimmtes zeitabhängiges Signal führenden Punkte einer Probe in einem Rastermikroskop, mit einem Primärstrahlerzeuger, mit Vorrichtungen zur Ablenkung und Fokussierung des Primärstrahles (PE) mit einer Ansteuerung zur Einspeisung von Versorgungsspannungen und/oder Signalen in die Probe, mit einer Detektoranordnung zum Nachweis sekundärer Korpuskel der eine Anordnung zur Signalverarbeitung nachgeordnet ist, mit einer Vorrichtung zur Modulation eines innerhalb der Anordnung zwischen dem Primärstrahlerzeuger und der Signalverarbeitung auftretenden Signals, und mit einer Schaltungsanordnung zur Ansteuerung der Vorrichtung zur Modulation, **gekennzeichnet** durch eine zwischen der Schaltungsanordnung - (SR) und der Vorrichtung zur Modulation (BBS, SP) angeordnete Vorrichtung (EXOR) zur Negierung des bestimmten oder negierten Signals, und einem mit dieser Vorrichtung verbundenen ersten Signalgenerator (G) zu deren Umschaltung von einer negierenden in eine nichtnegierende Betriebsweise.

15. Anordnung nach Anspruch 14, **gekennzeichnet** durch einen der Anordnung zur Signalverarbeitung (SV) nachgeschalteten Integrator (INT) und einer dem Integrator (INT) nachgeschalteten ersten Vorrichtung zur Demodulation (LIV).

16. Anordnung nach Anspruch 14 oder 15, **gekennzeichnet** durch einen zweiten Signalgenerator (GDL) und ein von diesem zweiten Signalgenerator (GDL) gesteuertes Verzögerungsglied (DL), dessen Ausgangssignal der Schaltungsanordnung (SR) zugeführt wird, so daß das bestimmte Signal und das durch Negation erzeugte Signal phasenverschoben gegenüber dem ersten Signal der Vorrichtung zur Modulation (BBS, SP) zugeführt wird, wobei die Phasenverschiebung periodisch mit der durch den zweiten Signalgenerator (GDL) vorgegebenen zweiten Frequenz ($f_2$) verändert wird, und eine der ersten Vorrichtung zur Demodulation (LIV) vor-oder nachgeschalteten zweiten Vorrichtung zur Demodulation (BP, AMD).

17. Anordnung nach einem der Ansprüche 14 bis 16, dadurch **gekennzeichnet**, daß ein phasenempfindlicher Detektor (LIV) als Vorrichtung zur Demodulation vorgesehen ist.

18. Anordnung nach einem der Ansprüche 14 bis 16, dadurch **gekennzeichnet**, daß ein auf die erste oder zweite Frequenz ($f_1$, $f_3$) abgestimmtes Bandpaßfilter (BP) mit nachgeschaltetem Amplitudendemodulator (AMD) als Vorrichtung zur Demodulation vorgesehen ist.

19. Anordnung nach Anspruch 14, **gekennzeichnet** durch einen Bitfolgengenerator, dessen Ausgangssignal der Vorrichtung zur Negierung - (EXOR) des bestimmten oder negierten Signals zugeführt wird, einem der Anordnung zur Signalverarbeitung (SV) nachgeschalteten Integrator (INT) und einer dem Integrator (INT) nachgeschalteten Vorrichtung zur Demodulation.

20. Anordnung nach Anspruch 14 oder 19, dadurch **gekennzeichnet**, daß die Vorrichtung zur Demodulation einen Korrelator enthält.

21. Anordnung nach einem der Ansprüche 14 bis 20, **gekennzeichnet** durch ein Strahlmodulationssystem (BBS) zur Modulation des Primärstrahles (PE) als Vorrichtung zur Modulation.

22. Anordnung nach einem der Ansprüche 14 bis 20, **gekennzeichnet** durch ein Spektrometer - (SP) als Vorrichtung zur Modulation des Stroms der Sekundärkorpuskeln (SE).

23. Anordnung nach einem der Ansprüche 14 bis 20, **gekennzeichnet** durch einen Detektor - (DT), bei dem die am Absaugnetz anliegende Spannung veränderbar ist.

24. Anordnung nach einem der Ansprüche 14 bis 20, dadurch **gekennzeichnet**, daß zwischen der Anordnung zur Signalverarbeitung (SV) und dem Integrator (INT) ein Mischer zwischengeschaltet ist, dessen zweiter Eingang mit dem Ausgang der Vorrichtung zur Negation (EXOR) des bestimmten und des negierten Signals verbunden ist.

25. Anordnung nach einem der Ansprüche 14 bis 24, **gekennzeichnet** durch eine Vorrichtung zur Aufzeichnung (CRT) eines Ausgangssignals und gegebenenfalls eines Topographiesignals.

0 226 913

# FIG 1

# FIG 2